# FASCICULE DE BREVET EUROPEEN

(11) **EP 2 326 157 B1**
(45) Date de publication et mention de la délivrance du brevet: **21.07.2021**
(21) Numéro de dépôt: 10191683.1
(22) Date de dépôt: 18.11.2010
(51) Int. Cl.: H05K 5/00, H04M 1/02, G09F 7/02, G09F 7/06

(54) **Portier électrique**
Elektrische Türsprechanlage
Electrical door intercom

(30) Priorité: 19.11.2009 FR 0958192
(43) Date de publication de la demande: 25.05.2011
(73) Titulaire: Cogelec, 85290 Mortagne-sur-Sèvre (FR)
(72) Inventeur: Leclerc, Roger, 85290, Mortagne sur Sevre (FR)
(74) Mandataire: Colombo, Michel

(56) Documents cités:
- EP-A1- 1 820 426
- DE-U1- 7 910 265
- DE-U1-202005 005 834
- DE-U1-202006 004 316
- DE-U1-202006 006 216

## Description

L'invention concerne un portier électrique.

Le portier électrique est un équipement, généralement situé à l'entrée d'une résidence, permettant d'appeler un combiné audiophonique d'un des résidents de cette résidence pour que celui-ci, en réponse, autorise ou interdise l'accès à la résidence. Typiquement, le portier électrique comporte donc aussi une unité de commande du déverrouillage et/ou du verrouillage d'au moins une porte d'accès à la résidence en fonction d'une commande transmise par le combiné du résident appelé.

Des portiers électriques connus comportent :
- au moins un bouton d'appel, chaque bouton déclenchant un appel vers un combiné audiophonique respectif d'un résident lorsqu'il est activé par un visiteur,
- au moins une étiquette remplaçable associée chacune à un bouton d'appel respectif, chaque étiquette comportant le nom du résident appelé lorsque le bouton d'appel associé est activé.

Plus précisément, ces portiers électriques connus comportent également :
- un porte-étiquettes équipé d'une face avant destinée à être exposée à l'extérieur de la résidence, et
- au moins une étiquette remplaçable apte à être fixée sur cette face avant du porte-étiquettes.

Les étiquettes connues sont en plastique ou en papier. Elles sont reçues dans le porte-étiquettes. Le porte-étiquettes comprend une ou plusieurs fenêtres transparentes derrière lesquelles sont logées ces étiquettes. Ces fenêtres transparentes empêchent les visiteurs d'arracher les étiquettes tout en permettant à ces visiteurs de consulter le nom marqué sur l'étiquette. Ces fenêtres transparentes protègent donc les étiquettes. Les fenêtres transparentes sont, dans l'immense majorité des cas, réalisées en polycarbonate.

Les portiers électriques, de par leur situation dans un emplacement accessible aux visiteurs, sont souvent victimes d'actes de vandalisme. En particulier, l'un des actes de vandalisme les plus fréquent consistent à exposer la fenêtre transparente à la flamme d'un briquet. Cette fenêtre transparente s'obscurcit ce qui rend illisible l'étiquette située derrière.

L'invention vise à remédier à cet inconvénient en proposant un portier électrique moins vulnérable, en particulier, vis-à-vis d'une attaque au briquet des fenêtres transparentes.

Elle a donc pour objet un portier électrique conforme à la revendication 1.

Dans le portier électrique ci-dessus, le problème de la vulnérabilité de la fenêtre transparente aux tentatives de vandalisme est résolu en supprimant cette fenêtre. La suppression de cette fenêtre transparente est rendue possible par le fait que les étiquettes elles-mêmes résistent au feu et aux dégradations liées à des coups violents portés sur cette étiquette. De plus :
- plaquer l'étiquette sur la platine rend très difficile d'enfoncer cette étiquette à l'aide de coups tels que des coups de marteau;
- placer l'étiquette dans un logement borgne ajusté à sa taille rend difficile l'arrachage de cette étiquette.

Les modes de réalisation de ce portier électrique peuvent comporter une ou plusieurs des caractéristiques des revendications dépendantes.

Ces modes de réalisation du portier électrique présente en outre les avantages suivants :
- raccorder électriquement les étiquettes à la platine permet de former un écran métallique continu qui protège plus efficacement l'intérieur du portier électrique des champs électromagnétiques appliqués à partir de la face avant du portier électrique,
- réaliser l'étiquette dans un matériau dont l'indice de dureté de ROCKWELL HRB est supérieur à 50 accroît sa durée de vie;
- réaliser l'étiquette en acier inoxydable ou en aluminium facilite son nettoyage;
- sculpter le nom en creux ou en relief rend le maquillage de ce nom plus difficile;
- utiliser une étiquette dans lequel une multitude de trous est réalisée permet d'éclairer cette étiquette par l'arrière.

L'invention sera mieux comprise à la lecture de la description qui va suivre, donnée uniquement à titre d'exemple non limitatif et faite en se référant aux dessins sur lesquels :
- la figure 1 est une illustration schématique d'un système de contrôle d'accès à une résidence comportant un portier électrique,
- la figure 2 est une illustration schématique et en vue de côté du portier électrique de la figure 1,
- la figure 3 est une illustration schématique et partielle en vue de devant du portier électrique de la figure 1,
- les figures 4, 6 et 7 sont des illustrations schématiques et en coupe d'un porte-étiquettes du portier électrique dans différentes positions de fonctionnement;
- la figure 5 est un organigramme d'un procédé de remplacement d'une étiquette du portier électrique de la figure 1

Dans ces figures, les mêmes références sont utilisées pour désigner les mêmes éléments.

Dans la suite de cette description, les caractéristiques et fonctions bien connues de l'homme du métier ne sont pas décrites en détails.

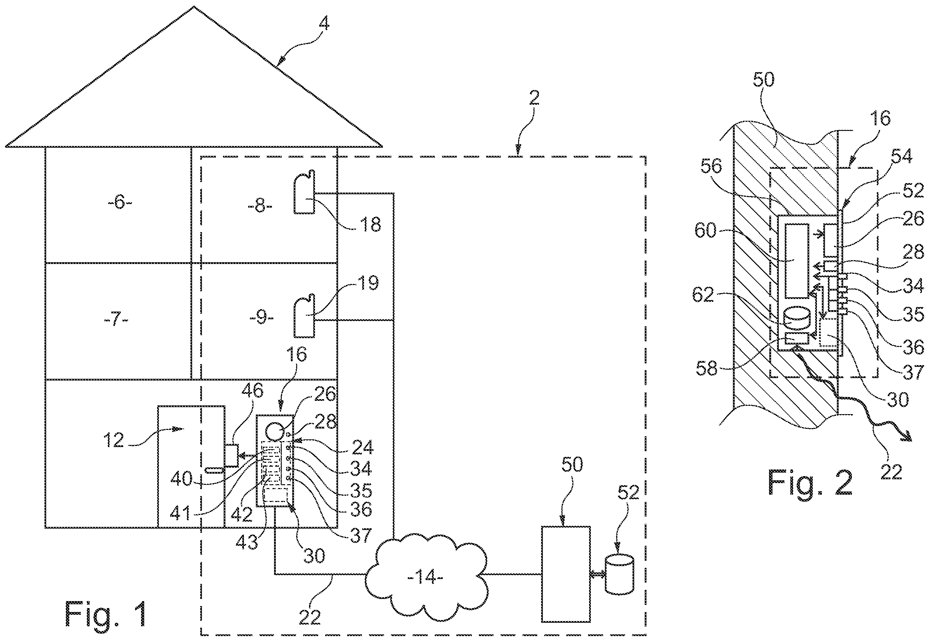

La figure 1 représente un système 2 de contrôle d'accès à une résidence 4. Typiquement, la résidence 4 est un habitat collectif comportant plusieurs appartements. Par exemple, la résidence 4 comporte au moins quatre appartements 6, 7, 8 et 9.

La résidence 4 est équipée d'une porte d'accès 12 à la résidence.

Le système 2 permet d'autoriser, et en alternance, d'interdire l'accès à la résidence 4 à un visiteur.

A cet effet, chaque résident de la résidence 4 est équipé d'un combiné audiophonique raccordé, par l'intermédiaire d'un réseau 14 de transmission d'informations à un portier électrique 16 situé à proximité de la porte 12.

Pour simplifier l'illustration, seuls deux combinés audiophoniques 18, 19 ont été représentés. Ces combinés sont par exemples des téléphones mobiles raccordés au réseau 14 par l'intermédiaire d'une liaison sans fil.

Par exemple, le réseau 14 est un réseau téléphonique public. Il peut s'agir d'un réseau à commutation de paquets ou d'un réseau à commutation de circuits.

Le portier 16 remplit la fonction d'interphone en permettant à un visiteur présent devant ce portier d'établir une conversation audiophonique avec le résident appelé. A cet, effet, le portier 16 est raccordé au réseau 14 par l'intermédiaire d'une liaison 22 de transmission d'informations. De préférence, cette liaison 22 est également une liaison de transmission d'informations sans fil.

Le portier 16 est équipé :
- d'un porte-étiquettes 24,
- d'un haut-parleur 26, et
- d'un microphone 28.

Le portier 16 peut également comprendre des équipements optionnels 30 tels que :
- un clavier permettant à un aveugle de composer un code d'appel d'un des combinés d'un résident, ou
- un lecteur de badge permettant d'autoriser et, en alternance d'interdire l'accès à la résidence 4 en fonction d'informations contenues dans un badge présenté devant ce lecteur.

Le porte-étiquettes 24 comprend ici autant de boutons d'appel que de résidents. Ici, pour simplifier l'illustration, seuls quatre boutons d'appel 34 à 37 ont été représentés. Chaque bouton d'appel déclenche, lorsqu'il est activé, un appel vers le combiné d'un résident particulier. Par exemple, les boutons sont des boutons poussoirs qui sont activés lorsqu'un visiteur les enfonce.

Le porte-étiquettes 24 comprend également une étiquette associée à chaque bouton d'appel. Ainsi, le porte-étiquettes 24 comprend quatre étiquettes 40 à 43 associées, respectivement, aux boutons d'appel 34 à 37. Sur chacune de ces étiquettes est marqué le nom du résident appelé lorsque le bouton associé est activé.

Le système 2 comprend également un mécanisme 46 de verrouillage et, en alternance, de déverrouillage de la porte 12. Ce mécanisme 46 est commandé par le portier 16 en réponse à la réception d'une commande de verrouillage ou de déverrouillage transmise par l'un des combinés 18 et 19.

Dans ce mode de réalisation particulier, le système 2 comprend également un serveur 50 raccordé au portier 16 par l'intermédiaire du réseau 14. Par exemple, ce serveur 50 permet de configurer le portier 16. A cet effet, le serveur 50 est associé à une mémoire 52 dans laquelle sont enregistrés différents paramètres de configuration du portier 16.

La figure 2 représente le portier 16 encastré dans un mur 50 de la résidence 4. Seule la face avant 52 de ce portier 16 est directement accessible depuis l'extérieur de la résidence 4. Ici, la face avant du portier 16 et du porte-étiquettes 24 sont confondues. Par exemple, cette face avant 52 est constituée par la face avant d'une même platine antivandale 54. Une telle platine 54 est typiquement réalisée en métal de manière à résister aux différentes tentatives de vandalisme. Par exemple, cette platine est une plaque en inox de plus de 2 à 3 mm d'épaisseur ou une plaque en aluminium de plus de 3 à 4 mm d'épaisseur.

L'ensemble des composants électroniques qui constitue le haut-parleur 26, le microphone 28 et les équipements optionnels 30 sont situés derrière cette platine 54 à l'intérieur d'une niche 56 creusée dans l'épaisseur du mur 50.

Le portier 16 comprend également, logé à l'intérieur de la niche 56 :
- un émetteur-récepteur 58 permettant de raccorder le portier 16 au réseau 14,
- une unité de commande 60 des différents équipements du portier 16, et
- une mémoire 62 raccordée à l'unité 60 de commande.

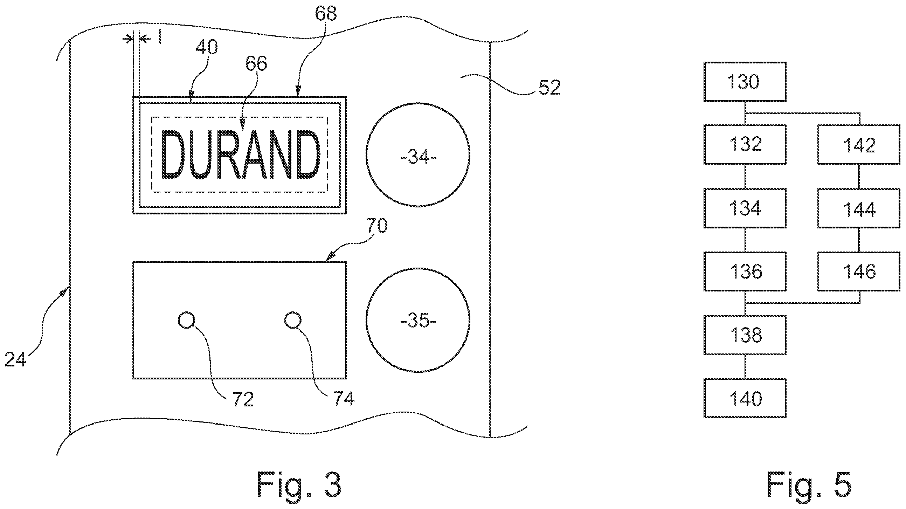

Typiquement, l'unité 60 est réalisée à partir de calculateurs électroniques programmables aptes à exécuter des instructions enregistrées sur un support d'enregistrement d'informations. A cet effet, les instructions nécessaires à l'exécution du procédé de la figure 5 sont enregistrées dans la mémoire 62.

L'accès à l'intérieur de la niche 56 n'est possible qu'en ouvrant le portier 16. L'ouverture du portier 16 consiste par exemple à déverrouiller, à l'aide d'un outillage spécial la platine 54 pour que l'accès à l'intérieur de la niche 56 soit rendu possible.

La figure 3 représente plus en détail une partie de la face avant 52 du porte-étiquettes 24. Les étiquettes identifiant les différents résidents sont fixées sur cette face avant.

De préférence, les étiquettes sont similaires les unes aux autres et seules l'étiquette 40 est maintenant décrite plus en détail.

L'étiquette 40 est directement exposée à l'extérieur sans être protégée par une fenêtre transparente. L'étiquette 40 comporte le nom 66 du résident appelé lorsque le bouton 34 qui lui est associé est activé. Ce nom est sculpté en relief ou en creux dans le matériau constituant l'étiquette. Ici, le nom 66 est gravé en creux dans la matière formant l'étiquette par un laser. Le nom est ainsi marqué de façon indélébile sur l'étiquette.

Pour résister aux tentatives de vandalisme, l'étiquette 40 est réalisée dans un matériau incassable et ininflammable.

Par incassable, on désigne un matériau indéformable dont l'indice de dureté de ROCKWELL HRB est supérieur à 50 et, de préférence, supérieur à 70. De préférence, ce matériau est au moins aussi dur qu'un acier inoxydable ou qu'un alliage d'aluminium. Par exemple, la dureté du matériau utilisé pour réaliser l'étiquette 40 peut être comparée à celle d'un autre métal en utilisant un indice de dureté de ROCKWELL HRC ou HRB.

Par ininflammable on désigne un matériau indestructible et indéformable lorsqu'il est chauffé à l'aide d'une flamme sur toute sa surface pendant cinq minutes. Typiquement, la température de la flamme est de 350° C.

Par exemple, l'étiquette 40 est réalisée en acier inoxydable dépoli ou en aluminium.

De manière à rendre l'arrachement de l'étiquette 40 plus difficile, celle-ci est reçue dans un logement borgne 68 creusé dans l'épaisseur de la platine 54. Ici, le porte-étiquettes comprend un logement borgne par étiquette.

Les dimensions de l'étiquette 40 correspondent très précisément aux dimensions du logement 68 de manière à ce que l'interstice d'épaisseur I qui existe entre le bord de l'étiquette 40 et le bord du logement 68 soit suffisamment petit pour rendre impossible l'insertion d'une lame de couteau dans cet interstice. Par exemple, l'épaisseur I de l'interstice est inférieure ou égale à 0,2 ou 0,3 mm.

La face arrière de l'étiquette 40 est entièrement en appui sur le fond du logement 68. Ainsi, même si des coups de marteau sont portés sur cette étiquette 40, celle-ci ne s'enfonce pas. De plus, l'étiquette 40 est ainsi en contact électrique avec la platine 54. Cette continuité électrique entre la platine et les étiquettes crée un écran continu qui protège les différents équipements électriques du portier 16 logés à l'intérieur de la niche 56 vis-à-vis des champs électromagnétiques. En particulier, cela renforce la résistance du portier électrique à des tentatives de dégradation par application de forts champs électromagnétiques tels que ceux appliqués à l'aide d'un pistolet Taser®.

Sur la figure 3, un logement 70 dépourvu d'étiquette est également visible. Deux orifices traversants 72 et 74 destinés à recevoir chacun une broche de l'étiquette sont creusés à travers la platine 54. Ces orifices 72 et 74 sont complètement obturés par l'étiquette lorsque celle-ci est fixée dans le logement 70.

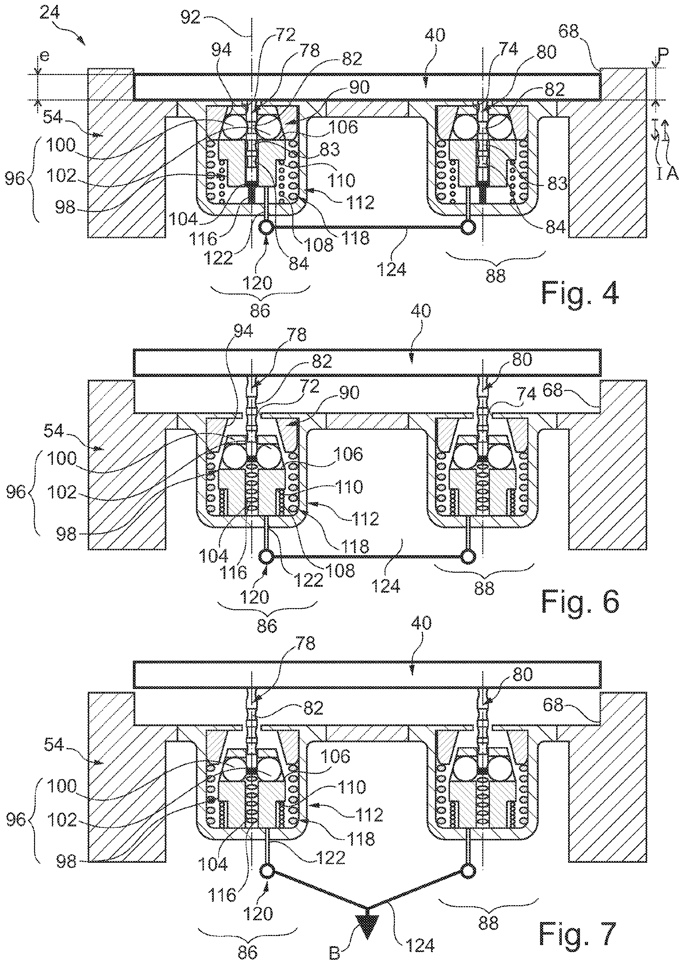

La figure 4 représente une vue en coupe transversale du porte-étiquettes 24 au milieu de l'étiquette 40.

L'étiquette 40 a une épaisseur e strictement inférieure à la profondeur P du logement 68. Ainsi, l'étiquette 40 ne crée aucune saillie au-delà de la face avant 52 ce qui la rend plus difficile à arracher.

L'étiquette 40 comporte également deux broches 78, 80 fixées sans aucun degré de liberté sur sa face arrière. Ces broches 78 et 80 s'étendent perpendiculairement à la face arrière. L'extrémité libre de ces broches est pointue.

Dans le cas particulier de la figure 4, les broches 78 et 80 sont complètement enfoncées à l'intérieur, respectivement, des orifices 72 et 74.

Chacune des broches 78, 80 comprend au moins un relief en creux ou en bosse dans sa circonférence. Dans ce mode de réalisation, chaque broche 78, 80 comprend trois renfoncements 82 à 84. Ici, chacun de ces renfoncements est une gorge, par exemple circulaire, creusée sur toute la circonférence de la broche.

Le porte-étiquettes 24 comprend également pour chaque broche un mécanisme d'agrippage de cette broche. Ici, le porte-étiquettes 24 comprend deux mécanismes 86 et 88 d'agrippage, respectivement, des broches 78 et 80. Ces mécanismes d'agrippage permettent de rendre l'arrachement de l'étiquette 40 très difficile. Ils sont uniquement accessible depuis l'intérieur du portier 16 et logé dans la niche 56.

Ici, ces mécanismes 86 et 88 sont identiques et seul le mécanisme 86 est décrit plus en détail.

Le mécanisme 86 comprend un collier 90 entourant l'orifice 72. L'axe de révolution de ce collier est confondu avec un axe 92 le long duquel est introduite et retirée la broche 78 à l'intérieur de l'orifice 72.

Une ouverture en forme de tronc de cône traverse le centre du collier 90. Cette ouverture crée une face tronconique 94 allant en s'évasant dans la direction d'enfoncement de la broche 78 à l'intérieur de l'orifice 72. Cette direction est repérée par une flèche I sur la figure 4. La direction opposée d'extraction de l'étiquette 40 est représentée par une flèche A.

Le mécanisme 86 comprend également un arrêtoir 96 déplaçable entre :
- une position active (représentée sur la figure 4) dans laquelle des butées mobiles 100 et 102 sont maintenues dans des positions de verrouillage, et
- une position rétractée (représentée sur les figures 6 et 7) dans laquelle les butées mobiles 100 et 102 sont amenées dans des positions escamotées.

L'arrêtoir 96 permet de déplacer les butées mobiles 100 et 102 entre les positions de verrouillage et les positions escamotées.

A cet effet, l'arrêtoir 96 comprend un corps 98 dans lequel sont reçues les deux butées mobiles 100 et 102. Le corps 98 présente une tête conique reçue dans l'ouverture en forme de tronc de cône du collier 90. Cette tête conique se prolonge, dans la direction I, par une queue cylindrique dont l'axe de révolution et confondu avec l'axe 92. Le corps 98 est traversé de part en part par un trou 104 qui s'étend le long de l'axe 92. Ce trou est destiné à recevoir la broche 78 à coulissement.

La tête conique est également traversée de part en part par un couloir 106 qui s'étend le long d'un axe perpendiculaire à l'axe 92. Les butées 100 et 102 sont disposées de part et d'autre de l'axe 92 à l'intérieur du couloir 106.

Les butées 100 et 102 sont déplaçables à l'intérieur de ce couloir 106. Plus précisément, chaque butée mobile est déplaçable entre :
- la position de verrouillage (représentée sur la figure 4) dans laquelle une partie de la butée est reçue dans le renfoncement 82 de manière à verrouiller en translation la broche 78 par coopération de forme avec ce renfoncement, et
- une position escamotée dans laquelle aucune partie de la butée mobile n'est reçue dans le renfoncement 78 de manière à libérer la broche en translation dans l'orifice 72.

A cet effet, chacune des butées mobiles 100 et 102 comporte une partie conformée pour être reçue dans le renfoncement 78.

Chacune de ces butées mobiles comprend également une autre partie directement en appui sur la face tronconique 94 lorsque l'arrêtoir 96 est dans sa position active. Dans cet état, la face 94 exerce sur la butée une force de maintien qui retient la butée à l'intérieur du renfoncement 82.

Par exemple, les butées 100 et 102 sont des billes.

Le mécanisme 86 comprend des moyens de rappel sollicitant en permanence l'arrêtoir 96 vers sa position active. Ici, ces moyens de rappel sont formés d'un ressort hélicoïdal 108 en appui d'un côté sur un épaulement 110 aménagé dans la queue cylindrique du corps 98 et de l'autre côté sur le fond d'un carter 112 dans lequel est reçu l'ensemble des éléments constitutifs du mécanisme 86.

Ici, le corps 98 est réalisé dans un matériau magnétisable propre à être déplacé par un champ magnétique. Par exemple, le corps 98 est réalisé dans un matériau ferromagnétique tel que le fer.

Des moyens élastiques sont également prévus pour éjecter la broche 78 de l'orifice 72 lorsque l'arrêtoir est dans sa position rétractée. Ici, ces moyens élastiques sont formés d'un ressort 116 interposés entre la pointe de la broche 78 et le fond du carter 112.

Enfin, le mécanisme 86 comprend un actionneur électrique 118 et un actionneur mécanique 120 permettant de déplacer l'arrêtoir 96 de sa position active vers sa position rétractée à l'encontre de la force exercée par le ressort 108.

L'actionneur 118 est ici un actionneur électromagnétique capable de créer un champ magnétique propre à déplacer le corps 98 à l'encontre de la force exercée par le ressort 108. Par exemple, l'actionneur 118 est un bobinage entourant le corps 98. Lorsque ce bobinage est parcouru par un courant électrique, il crée un champ magnétique qui déplace le corps 98 et donc l'arrêtoir 96 dans la direction I.

L'actionneur mécanique 120 comprend ici une tige 122 solidaire du corps 98 et dont une extrémité libre fait saillie en dehors du carter 112. Cette tige 122 est montée à coulissement à l'intérieur d'une ouverture aménagée dans le fond du carter 112.

Une ficelle 124 raccorde les extrémités libres des tiges 122 des mécanismes 86 et 88 pour déplacer simultanément ces deux tiges lorsque la ficelle 124 est tirée manuellement par un opérateur dans la direction I. La force de traction alors exercée sur la ficelle 124 est représentée par une flèche B sur la figure 7.

Le fonctionnement du portier 16 va maintenant être décrit en regard du procédé de la figure 5.

Initialement, lors d'une étape 130, la nouvelle étiquette qui doit remplacer l'étiquette 40 est commandée. Par exemple, la nouvelle étiquette est commandée en ligne en se connectant sur un site Internet hébergé sur le serveur 50.

Après avoir reçu la nouvelle étiquette, lors d'une étape 132, le portier 16 est basculé dans un mode de remplacement d'une étiquette. Différentes méthodes sont possibles pour basculer dans ce mode de remplacement. Par exemple, si un clavier est présent sur le portier 16, alors l'opérateur tape un code spécial qui bascule le portier 16 dans le mode de remplacement.

Si le portier 16 est équipé d'un lecteur de badge, alors un opérateur équipé d'un badge spécial passe celui-ci devant le lecteur. En réponse, le portier 16 bascule dans le mode de remplacement d'une étiquette.

Enfin, une autre méthode peut consister à appeler à l'aide d'un téléphone mobile le serveur 50. Ensuite, un code spécial reçu par exemple en même temps que la nouvelle étiquette est tapé sur le clavier du téléphone mobile. En réponse, le serveur 50 contacte le portier 16 par l'intermédiaire du réseau 14 et le fait passer en mode de remplacement d'une étiquette.

Une fois que le portier 16 est en mode de remplacement d'une étiquette, celui-ci attend qu'on lui indique quelle est l'étiquette à remplacer. Dès lors, lors d'une étape 134, l'opérateur sélectionne l'étiquette à remplacer en appuyant sur le bouton d'appel associé à cette étiquette. On suppose ici que l'étiquette 40 est sélectionnée lors de cette étape 134.

En réponse, lors d'une étape 136, le portier 16 commande le déplacement des arrêtoirs 96 associés à l'étiquette 40 vers leurs positions rétractées. Lors de cette étape, l'unité 60 de commande génère une commande électrique qui est transmise uniquement aux actionneurs 118 des mécanismes 86 et 88 qui agrippent l'étiquette 40. La commande électrique est par exemple une impulsion de courant dont la durée est suffisante pour permettre à l'arrêtoir de se déplacer de sa position active vers sa position rétractée.

En réponse, le corps 98 se déplace vers le fond du carter 112. Ce déplacement libère suffisamment d'espace pour que les butées 100 et 102 se dégagent du renfoncement 82. Le ressort 116 pousse alors la broche 78 vers l'extérieur de l'orifice. Cette poussée écarte les butées mobiles 100 et 102 ce qui déverrouille définitivement la broche 78. Ainsi, l'étiquette 40 est éjectée du logement 68.

Lorsque l'impulsion de courant électrique s'arrête, lors d'une étape 138, l'arrêtoir 96 retourne automatiquement vers sa position de verrouillage sous l'action du ressort 108. Cela entraîne donc aussi automatiquement le déplacement puis le maintien des butées 100 et 102 dans leur position de verrouillage.

Ensuite, lors d'une étape 140, l'opérateur enlève l'étiquette éjectée 40 et enfonce dans les orifices 72 et 74 les broches 78 et 80 de la nouvelle étiquette. L'enfoncement de chaque broche, entraîne, le déplacement de l'arrêtoir dans la direction I et le déplacement des butées 100 et 102 vers leur position escamotée. Ainsi, l'introduction des broches 78 et 80 dans les orifices 72, 74 est aisée. La broche est enfoncée jusqu'à ce que la face arrière de la nouvelle étiquette vienne en butée sur le fond du logement 68. Dans cette position, les butées 100 et 102 sont reçues dans le renfoncement 82 et verrouillent les broches 78 et 80 à l'intérieur des orifices 72 et 74.

Dans la position de verrouillage, toute tentative d'arrachage de l'étiquette tire l'arrêtoir 96 dans la direction d'arrachement A. Cela conduit à augmenter la force de maintien exercée par la paroi 94 sur les butées mobiles 100 et 102. Par conséquent, l'arrachage de l'étiquette est rendu très difficile.

En absence de courant électrique, les étiquettes peuvent également être remplacées en utilisant l'actionneur mécanique 120. Pour cela, lors d'une étape 142, l'opérateur ouvre le portier électrique de manière à pouvoir accéder à la ficelle 124. Puis lors d'une étape 144, l'opérateur tire la ficelle 144 dans la direction I de manière à déplacer simultanément les arrêtoirs 96 vers leurs positions escamotées. Cela provoque l'éjection de l'étiquette 40. Ensuite, lors d'une étape 146, la ficelle 124 est relâchée et les arrêtoirs 96 reviennent vers leurs positions actives sous l'effet des sollicitations du ressort 108. Ensuite, le reste du procédé de remplacement de l'étiquette est identique au cas où les actionneurs électriques sont utilisés pour éjecter l'étiquette.

De nombreux autres modes de réalisation sont possibles. Par exemple, le nom du résident peut être remplacé par un identifiant d'un appartement tel que son numéro.

Le nombre de logements borgnes prévus pour recevoir les étiquettes peut varier. Dans un cas extrême, un seul logement borgne est prévu pour recevoir l'ensemble des étiquettes. Dans ce cas, les étiquettes sont contiguës les unes aux autres pour empêcher l'insertion entre deux étiquettes d'une lame de couteau. L'interstice entre les étiquettes sera donc de préférence inférieure à 0,2 ou 0,3 mm.

Le nom du résident peut être sculpté dans l'étiquette par d'autre moyen qu'une gravure laser. Par exemple, le nom est frappé ou embossé dans l'étiquette.

Une multitude de trous traversants peuvent être réalisés dans l'étiquette de manière à laisser passer la lumière de l'arrière de l'étiquette vers l'avant. Un tel mode de réalisation permet d'éclairer l'étiquette par l'arrière. Dans ce cas, l'étiquette est par exemple réalisée à partir d'un grillage dans lequel on vient boucher certaines cases pour inscrire le nom.

En variante, l'épaisseur e de l'étiquette est supérieure à la profondeur P du logement borgne. De préférence, dans cette variante, les arêtes de l'étiquette en saillie au-delà de la face avant de la platine sont arrondies ou biseautées de manière à offrir un minimum de prise à toute tentative d'arrachage à l'aide d'un couteau ou d'un objet similaire.

En variante, le portier électrique ou le porte-étiquettes comprend un seul bouton d'appel associé à une seule étiquette.

Les broches de l'étiquette peuvent comporter des bossages à la place des renfoncements pour coopérer avec les butées mobiles afin de verrouiller en translation la broche dans l'orifice.

Les moyens élastiques ou les moyens de rappel du mécanisme d'agrippage peuvent être réalisés de manière différente. Par exemple, une lame ressort peut être utilisée ou un matériau élastomère peut être utilisé pour remplacer le ressort 108 ou le ressort 116. Les moyens de rappel peuvent également être obtenu en utilisant une ou plusieurs pièces aimantées. Par exemple, un ou plusieurs aimants sont utilisés pour attirer le corps 98 vers sa position de verrouillage. Il est également possible de repousser le corps 98 vers la position de verrouillage. Par exemple, des faces en vis-à-vis du corps 98 et du fond du carter 112 sont des faces aimantées de même polarité qui se repoussent.

Dans une variante simplifiée, le ressort 116 est omis.

Le nombre de butées mobiles peut varier. Dans un cas simplifié, une seule butée mobile est utilisée. Dans une autre variante, plus de deux butées mobiles sont utilisées. Dans ce cas là, de préférence, les butées mobiles sont uniformément réparties sur la circonférence de la broche de l'étiquette.

Les butées mobiles peuvent avoir d'autres formes que celle d'une bille. Par exemple, il peut s'agir d'un cylindre monté à coulissement à l'intérieur du couloir 106.

Dans une autre variante, le mécanisme d'agrippage est solidaire de l'étiquette et les broches sont solidaires du porte-étiquettes.

Les boutons d'appel ne sont pas nécessairement des boutons enfonçables. Par exemple, il peut s'agir d'un capteur qui détectent la proximité d'un doigt.

Le portier peut comporter des éléments supplémentaires tels qu'une caméra et un écran de manière à permettre l'établissement d'une vidéo conférence avec le résident appelé.

Le système de contrôle d'accès ne comporte pas nécessairement de serveur tel que le serveur 50.

De même, le système de contrôle d'accès peut utiliser d'autres réseaux qu'un réseau public. Par exemple, les combinés audiophoniques peuvent être raccordés au portier électrique à l'aide d'un réseau local à la résidence.

La face avant du porte-étiquettes 24 peut être, comme ici, confondue et formée d'un seul bloc avec la face avant du portier électrique. Toutefois, la face avant du porte-étiquettes 24 peut également être réalisé dans un bloc de matière différent qui est ensuite ajusté dans un logement prévu à cet effet dans la face avant du portier électrique. Dans ce dernier cas, le porte-etiquettes peut être fabriqué indépendamment du portier électrique.

Les étiquettes antivandales décrites ici peuvent être mises en œuvre indépendamment des mécanismes d'agrippage 86 et 88. Dans ce cas, soit d'autres mécanismes d'agrippage que les mécanismes 86 et 88 sont utilisés soit l'étiquette est fixée sur le porte-étiquettes par d'autres moyens qui ne nécessitent pas l'utilisation des broches 78 et 80. Par exemple, les étiquettes antivandales décrites ici peuvent être fixées sur le porte-étiquettes à l'aide de moyens qui nécessitent l'ouverture du portier électrique pour effectuer leur remplacement.

Le nombre de broches ainsi que le nombre de mécanismes d'agrippage associés peut être aussi petit que un ou, en variante, plus grand que deux.

D'autres méthodes pour faire passer le portier 16 dans le mode de remplacement d'une étiquette sont possibles. Par exemple, lorsque la nouvelle étiquette est expédiée, le serveur 50 programme le portier 16 pour que si le bouton d'appel associé à l'étiquette à remplacer est enfoncé, alors le portier 16 appelle le combiné audiophonique correspondant et passe automatiquement en mode de remplacement. Ensuite, le portier attend qu'un code de déverrouillage de l'étiquette soit communiqué à partir du combiné audiophonique appelé. A titre d'illustration, pour communiquer le code au portier, le résident appelé tape sur le clavier de son téléphone un code reçu en même temps que la nouvelle étiquette. Ce code est transmis au portier 16, par exemple, sous forme de tonalités DTMF (Dual Tone Multifrequency). Le portier 16 déverrouille l'étiquette à remplacer si le code reçu correspond au code attendu.

## Revendications

1. Portier électrique pour une résidence, ce portier comportant :
- au moins un bouton d'appel (34-37), chaque bouton déclenchant un appel vers un combiné audiophonique respectif d'un résident lorsqu'il est activé par un visiteur,
- un haut parleur (26) et un microphone (28) permettant à un visiteur, présent devant ce portier électrique, d'établir une conversation audiophonique avec le résident appelé,
- une unité de commande du déverrouillage et/ou verrouillage d'au moins une porte d'accès à la résidence en fonction d'une commande transmise par le combiné du résident appelé, et
- au moins une étiquette (40-43) remplaçable associée chacune à un bouton d'appel respectif, chaque étiquette comportant le nom du résident appelé lorsque le bouton d'appel associé est activé,
**caractérisé en ce que** :
• le portier comporte une platine antivandale (54) formant une face avant (52) du portier électrique exposée à l'extérieur, au moins un logement borgne (68) étant aménagé dans cette face avant pour recevoir la ou les étiquettes,
• l'étiquette (40-43) est directement exposée à l'extérieur du portier électrique sans être protégée par une fenêtre transparente, et réalisée dans un matériau incassable et ininflammable sur lequel est directement marqué le nom du résident, et
• la majorité de la face arrière de chaque étiquette (40-43) est plaquée sur le fond du logement borgne et les dimensions de chaque étiquette (40-43) sont ajustées aux dimensions du logement borgne correspondant pour que l'interstice entre l'étiquette et les bords du logement borgne soit inférieur à 0,3 mm lorsque l'étiquette est reçue dans ce logement borgne.

2. Portier selon la revendication 1, dans lequel la platine antivandale est pourvue d'orifices (72, 74) traversants de fixation pour fixer les étiquettes sur la face avant, et l'étiquette (40-43) est conformée pour obturer entièrement le ou les orifices de fixation utilisés pour la fixer sur ce portier électrique, l'étiquette et la platine étant en métal et électriquement raccordées l'une à l'autre.

3. Portier selon l'une quelconque des revendications précédentes, dans lequel l'étiquette (40-43) est réalisée dans un matériau dont l'indice de dureté de ROCKWELL HRB est supérieure à 50 et, de préférence, à 70.

4. Portier selon la revendication 3, dans lequel le matériau est indéformable et indestructible lorsqu'il est soumis à une flamme de 350° C pendant cinq minutes.

5. Portier selon la revendication 4, dans lequel le matériau est de l'acier inoxydable ou de l'aluminium.

6. Portier selon l'une quelconque des revendications précédentes, dans lequel le nom (66) est sculpté en creux ou en saillie dans le matériau formant l'étiquette.

7. Portier selon l'une quelconque des revendications précédentes, dans lequel l'étiquette (40-43) est réalisée dans un matériau non transparent à la lumière visible transpercé de plusieurs dizaines de trous pour laisser passer la lumière à travers cette étiquette.

## Patentansprüche

1. Elektrische Türsprechanlage für ein Wohngebäude, wobei diese Türsprechanlage Folgendes aufweist:
- mindestens einen Rufknopf (34-37), wobei jeder Knopf einen Anruf zu einem jeweiligen Audiohörer eines Bewohners auslöst, wenn er von einem Besucher aktiviert wird,
- einen Lautsprecher (26) und ein Mikrofon (28), die es einem Besucher, der sich vor dieser elektrischen Türsprechanlage befindet, gestatten, eine Audiokonversation mit dem angerufenen Bewohner herzustellen,
- eine Einheit zur Steuerung der Entriegelung und/oder Verriegelung mindestens einer Zugangstür des Wohngebäudes in Abhängigkeit von einem Befehl, der vom Hörer des angerufenen Bewohners übertragen wird, und
- mindestens ein wechselbares Etikett (40-43), das jeweils zu einem jeweiligen Rufknopf gehört, wobei jedes Etikett den Namen des angerufenen Bewohners aufweist, wenn der zugehörige Rufknopf aktiviert wird,
**dadurch gekennzeichnet, dass**:
• die Türsprechanlage eine Antivandalenplatte (54) aufweist, die eine Vorderseite (52) der elektrischen Türsprechanlage bildet, die zum Äußeren hin freiliegt, wobei mindestens eine Blindaufnahme (68) in dieser Vorderseite eingerichtet ist, um das oder die Etiketten aufzunehmen,
• das Etikett (40-43) direkt zum Äußeren der elektrischen Türsprechanlage freiliegt, ohne von einem transparenten Fenster geschützt zu sein, und aus einem bruchsicheren und feuerfesten Material hergestellt ist, auf dem direkt der Name des Bewohners steht, und
• der Großteil der Rückseite jedes Etiketts (40-43) auf den Boden der Blindaufnahme gedrückt ist und die Abmessungen jedes Etiketts (40-43) an die Abmessungen der entsprechenden Blindaufnahme angepasst sind, damit der Zwischenraum zwischen dem Etikett und den Rändern der Blindaufnahme kleiner als 0,3 mm ist, wenn das Etikett in dieser Blindaufnahme aufgenommen ist.

2. Türsprechanlage nach Anspruch 1, wobei die Antivandalenplatte mit durchgehenden Befestigungsöffnungen (72, 74) versehen ist, um die Etiketten auf der Vorderseite zu befestigen, und das Etikett (40-43) dazu ausgebildet ist, das oder die Befestigungsöffnungen, die dafür genutzt werden, es an dieser elektrischen Türsprechanlage zu befestigen, vollständig zu verschließen, wobei das Etikett und die Platte aus Metall und elektrisch miteinander verbunden sind.

3. Türsprechanlage nach einem der vorhergehenden Ansprüche, wobei das Etikett (40-43) aus einem Material hergestellt ist, dessen Rockwell-Härtezahl HRB größer als 50 und vorzugsweise als 70 ist.

4. Türsprechanlage nach Anspruch 3, wobei das Material unverformbar und unzerstörbar ist, wenn es fünf Minuten lang einer Flamme von 350 °C ausgesetzt ist.

5. Türsprechanlage nach Anspruch 4, wobei das Material rostfreier Stahl oder Aluminium ist.

6. Türsprechanlage nach einem der vorhergehenden Ansprüche, wobei der Name (66) vertieft oder hervorstehend im Material ausgebildet ist, das das Etikett bildet.

7. Türsprechanlage nach einem der vorhergehenden Ansprüche, wobei das Etikett (40-43) aus einem Material hergestellt ist, das für sichtbares Licht nicht transparent ist, das mit mehreren Dutzend Löchern durchbohrt ist, um das Licht durch dieses Etikett hindurchzulassen.

## Claims

1. Electric intercom for a residence, this intercom comprising:
- at least one call button (34-37), each button triggering a call to a respective audiophonic handset of a resident when it is activated by a visitor,
- a loudspeaker (26) and a microphone (28) allowing a visitor, present in front of this electronic intercom, to establish an audiophonic conversation with the called resident,
- a control unit for the unlocking and/or locking of at least one access door to the residence as a function of a command transmitted by the handset of the called resident, and
- at least one replaceable label (40-43), each associated with a respective call button, each label bearing the name of the resident called when the associated call button is activated,
**characterized in that**:
• the intercom comprises a vandal-proof plate (54) forming a front face (52) of the electric intercom that is exposed to the outside, at least one blind housing (68) being formed in this front face in order to receive the label or labels,
• the label (40-43) is directly exposed to the outside of the electric intercom without being protected by a transparent window, and made of an unbreakable and non-flammable material on which there is directly marked the name of the resident, and
• the majority of the rear face of each label (40-43) is pressed on the bottom of the blind housing, and the dimensions of each label (40-43) are tailored to the dimensions of the corresponding blind housing in order for the gap between the label and the edges of the blind housing to be less than 0.3 mm when the label is received in this blind housing.

2. Intercom according to Claim 1, wherein the vandal-proof plate is provided with fastening through-orifices (72, 74) for fastening the labels to the front face, and the label (40-43) is configured to entirely shut off the fastening orifice or orifices used for fastening it to this electric intercom, the label and the plate being made of metal and being electrically connected to one another.

3. Intercom according to either one of the preceding claims, wherein the label (40-43) is made of a material having a ROCKWELL HRB hardness index of more than 50 and, preferably, more than 70.

4. Intercom according to Claim 3, wherein the material is non-deformable and indestructible when it is subjected to a flame of 350°C for five minutes.

5. Intercom according to Claim 4, wherein the material is stainless steel or aluminium.

6. Intercom according to any one of the preceding claims, wherein the name (66) is sculpted so as to be recessed into or to project from the material forming the label.

7. Intercom according to any one of the preceding claims, wherein the label (40-43) is made of a material that is not transparent to visible light and cut through with several tens of holes to allow light to pass through this label.
